# EUROPEAN PATENT SPECIFICATION

(11) **EP 1 457 582 B1**
(45) Date of publication and mention of the grant of the patent: **25.04.2012**
(21) Application number: 02777982.6
(22) Date of filing: 28.10.2002
(51) Int. Cl.: C23C 14/24, H05B 33/10, H05B 33/14

(54) **DEVICE FOR VACUUM DEPOSITION**
VORRICHTUNG ZUR VAKUUMABSCHEIDUNG
DISPOSITIF DE METALLISATION SOUS VIDE

(30) Priority: 26.10.2001 JP 2001329674; 26.07.2002 JP 2002218624
(43) Date of publication of application: 15.09.2004
(73) Proprietor: Panasonic Corporation, Osaka 571-8501 (JP); Canon Tokki Corporation, Chuo-ku Tokyo 104-0061 (JP); Kido, Junji, Yonezawa-shi, Yamagata 992-0062 (JP)
(72) Inventor: KIDO, Junji, Yonezawa-shi, Yamagata 992-0062 (JP); NISHIMORI, Taisuke, Kadoma-shi, Osaka 571-8686 (JP); KISHI, Yasuo, Kadoma-shi, Osaka 571-8686 (JP); KONDO, Yukihiro, Kadoma-shi, Osaka 571-8686 (JP); NAKAGAWA, Teruo, Kadoma-shi, Osaka 571-8686 (JP); YANAGI, Yuuji, Nagaoka-shi, Niigata 940-0006 (JP); MATSUMOTO, Eiichi, Nagaoka-shi, Niigata 940-0006 (JP); MAKI, Syuuji, Nagaoka-shi, Niigata 940-0006 (JP)
(74) Representative: Pfenning, Meinig & Partner GbR
(86) International application number: PCT/JP2002/011193
(87) International publication number: WO 2003/035925

(56) References cited:
- EP-A1- 0 652 302
- EP-A2- 0 865 229
- WO-A2-00/28103
- DE-A1- 3 204 337
- JP-A- 9 272 703
- JP-A- 62 089 866
- JP-A- 2003 013 203
- JP-B2- 1 060 546
- JP-Y2- 6 000 449
- US-A- 4 655 168

## Description

### TECHNICAL FIELD

The present invention relates to a device for a vacuum deposition which evaporates an evaporation source under a vacuum atmosphere and deposits an evaporation substance to a deposited body.

### BACKGROUND ART

The vacuum deposition device is structured such that the evaporation source and the deposited body are arranged within a vacuum chamber, the deposited material is melted so as to be evaporated or the deposited material is sublimated by heating the evaporation source in a state in which an inner side of the vacuum chamber is pressure reduced, thereby being vaporized, and the vaporized substance is accumulated on a surface of the deposited body so as to be deposited. The vaporized substance which is heated and is generated from the evaporation source is linearly discharged in a normal direction from the evaporation source, however, since a discharge space is kept in a vacuum state, the vaporized substance linearly moves, and is attached to the surface of the deposited body arranged so as to oppose to the evaporation source, thereby being deposited.

However, since the vaporized substance is linearly discharged in the normal direction from the evaporation source, there is a lot of vaporized substance which does not move toward the deposited body. Since the vaporized material which does not move toward the deposited body as mentioned above is not attached to the surface of the deposited body, there are problems that a yield ratio of the evaporation source becomes low and a deposition speed to the surface of the deposited body becomes slow. Accordingly, as disclosed in Japanese Unexamined Patent Publication Nos. 4-45259 and 9-272703, there has been proposed a vacuum deposition device structured such that a space in which an evaporation source arranged within a vacuum chamber and a deposited body oppose to each other is surrounded by a tubular body, and the tubular body is heated at a temperature by which the substance of the evaporation source is vaporized, whereby the substance vaporized from the evaporation source is vacuum deposited to the surface of the deposited body through the inner side of the tubular body.

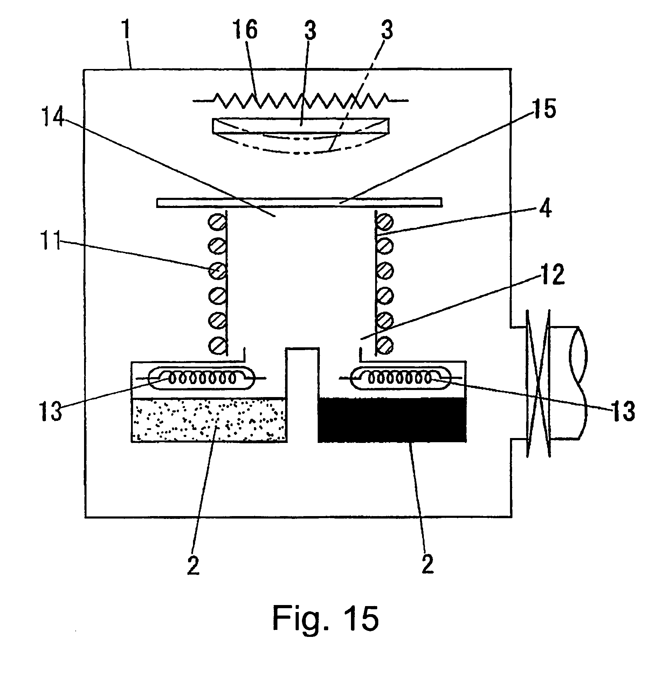

Fig. 15 shows an embodiment of the structure. In the structure, a tubular body 4 open to upper and lower sides is arranged within a vacuum chamber 1, and a heater 11 is wound around the tubular body 4 so as to heat the tubular body 4 An evaporation source 2 is arranged so as to face to an opening portion 12 in a lower end of the tubular body 4, and a deposition material can be vaporized by heating a heater 13. A deposited body 3 is arranged in an upper side of an opening portion 14 in an upper end of the tubular body 4, and the opening portion 14 can be opened and closed by a shutter 15. Reference numeral 16 denotes a heater for heating the deposited body 3.

In the structure mentioned above, when the deposited material is vaporized by pressure reducing an inner side of the vacuum chamber 1 and heating the evaporation source 2, and the shutter 15 is opened, the substance vaporized from the evaporation source 2 flies within the tubular body 4 so as to pass through the inner side of the tubular body 4, and is attached to the surface of the deposited body 3 through the opening portion 14 in the upper end of the tubular body 4, whereby the deposition can be achieved by accumulating the vaporized substance on the deposited body 3. Further, in the structure mentioned above, since a space in which the evaporation source 2 and the deposited body 3 are opposed to each other is surrounded by the tubular body 4, the vaporized substance can be moved toward the deposited body 3 while being reflected by the inner surface of the tubular body 4 in a state in which the vaporized substance generated from the evaporation source 2 is surrounded within the tubular body 4, and most of the vaporized substance generated from the evaporation source 2 can reach the surface of the deposited body 3, whereby it is possible to execute the deposition at a high yield ratio while reducing an amount which escapes without being attached to the deposited body 3. Further, since the tubular body 4 is heated by the heater 11, the tubular body 4 is reheated so as to be re-vaporized even in the case that the vaporized substance is attached to the inner surface of the tubular body 4. The re-vaporized substance reaches the deposited body 3 so as to form a deposition layer, and the vaporized substance is not accumulated on the tubular body 4 so as to lower the yield ratio.

As mentioned above, it is possible to execute the deposition at a high yield ratio by surrounding the space between the evaporation source 2 and the deposited body 3 by the heated tubular body 4, however, since the vaporized substance is linearly discharged in the normal direction from one evaporation source 2, an amount of accumulation of the deposited substance is different between a center portion and an end portion of the deposited body 3, and there is a problem that a film thickness of the deposition tends to be uneven. In other words, since a distance from the evaporation source 2 to the end portion of the deposited body 3 is longer than a distance from the evaporation source 2 to the center portion of the deposited body 3, the amount of accumulation of the deposited substance is more in the center portion of the deposited body 3 in which the distance from the evaporation source 2 is short, and the amount of accumulation of the deposited substance is less in the end portion of the deposited body 3 in which the distance from the evaporation source 2 is long. In particular, in the case that the space between the evaporation source 2 and the deposited body 3 is surrounded by the heated tubular body 4, the deposited substance attached to the inner periphery of the tubular body 4 is re-evaporated and discharged, so that there is a risk that an unevenness in the film thickness of the deposition becomes larger in accordance with the design of the tubular body 4.

The deposition can be executed in accordance with a method of vaporizing the deposition material arranged within a base portion of the tubular body 4, making the evaporation substance to fly within the tubular body 4, and attaching the flied vaporization substance to the deposited body 3 arranged so as to face to the opening portion 14 in the upper end of the tubular body 4 through the opening portion 14. However, in the structure mentioned above, in the case of applying the deposition to an entire surface of the surface of the deposited body 3, it is necessary to arrange the deposited body 3 so as to enter into an area of the opening portion 14 of the tubular body 4. Accordingly, it is necessary to make a magnitude of the opening portion 14 of the tubular body 4 larger than an area of the deposited body 3. For example, in the case that the deposited body 3 is a plate member having a dimension equal to or more than 200 mm in one line, it is necessary to form the opening portion 14 of the tubular body 4 equal to or larger than the deposited body.

In this case, the vaporized substance vaporized from the evaporation source 2 arranged within the base portion of the tubular body 4 flies within the tubular body 4 and reaches the opening portion 14, however, a distribution of concentration of the vaporized substance passing through the opening portion 14 is not uniform, but the concentration of the evaporated substance becomes higher particularly in a portion corresponding to a position where the evaporation source 2 is arranged, and the concentration of the vaporized substance becomes lower in a peripheral portion of the opening portion 14. Further, in the case that the area of the opening portion 14 of the tubular body 4 is small, the unevenness in the distribution of concentration of the vaporized substance does not become so large in the center portion and the peripheral portion, and no specific problem is generated. However, in the case that the opening portion 14 becomes a great area such as an area having one line equal to or larger than 200 mm, a difference of concentration is largely generated between the vaporized substance passing through the center portion of the opening portion 14 and the vaporized substance passing through the peripheral portion, so that there is generated a problem that the deposition film thickness become uneven such that the film thickness of the deposition film deposed on the deposited body 3 is thick in the center portion and thin in the peripheral portion.

EP 0 652 302 A shows a vacuum deposition device for coating a substrate using an evaporation source. The space between the evaporation source and the substrate is surrounded by a tubular body in the form of the walls of a retort, which is rectangular in cross section. The walls are heated to a temperature above the vaporization point of the source material. At the end of the tubular body which is adjacent to the substrate, a control member consisting of a plate having a pattern of holes or slots is provided in order to guide the flow of vaporized material. The shape of this member conforms to the contours of the substrate.

Us 4 655 168 A describes another vacuum deposition device in which the space between an evaporation source and a substrate is enclosed by an evaporation chamber in the form of a tubular member having a rectangular cross section. All parts of the device are heated to temperatures above the vaporization temperature of the substance to be deposited. Close to the substrate, a control means consisting of a sliding panel is provided within the tubular member. The tubular member is shaped in a 90° bend.

Also DE 320 43 37 A refers to a vacuum deposition device in which the space between the substrate and the evaporation source is enclosed by a tubular member, the walls of which are heated to a temperature above the vaporization temperature of the material being deposited. The tubular member has a rectangular opening and the substrate moves past this opening.

Finally, EP 0 865 229 A discloses a method for producing organic electroluminescent devices by forming a plurality of film layers including organic layers and a counter electrode layer, on an electrode mounted on a substrate, successively one after another in vacuum.

The present invention is made by taking the points mentioned above into consideration, and an object of the present invention is to provide a vacuum deposition which can apply a deposition to a deposited body having a great area at a uniform film thickness.

### DISCLOSURE OF THE INVENTION

This object according to the invention is solved by a vacuum deposition device comprising the features of claim 1. Preferred embodiments of this device are defined in the subclaims.

### BRIEF DESCRIPTION OF THE DRAWINGS

Fig. 1 is a cross sectional view of a vacuum deposition device not covered by the invention but useful for understanding the invention.
Fig. 2 is a plan view showing an example of a control member of the device shown in Fig. 1.
Fig. 3 shows a test of a vacuum deposition, in which Fig. 3 (a) is a graph of test results, and Fig. 3 (b) is a plan view showing a deposited body used in the test.
Fig. 4 shows another vacuum deposition device not covered by the invention, in which Figs. 4(a) and 4(b) are cross sectional views of respective parts.
Fig. 5 is a cross sectional view of a part of a vacuum deposition device not covered by the invention.
Fig. 6 is a cross sectional view of a part of a vacuum deposition device not covered by the invention.
Fig. 7 is a cross sectional view of a part of a vacuum deposition device not covered by the invention.
Fig. 8 is a cross sectional view of a part of a vacuum deposition device not covered by the invention.
Fig. 9 shows another vacuum deposition device not covered by the invention, in which Fig. 9 (a) is a front elevational cross sectional view and Fig. 9(b) is a plan view of a part thereof.
Fig. 10 shows a further vacuum deposition device not covered by the invention, in which Fig. 10(a) is a front elevational cross sectional view and Fig. 10(b) is a plan view of a part thereof.
Fig. 11 shows a still further vacuum deposition device not covered by the invention, in which Fig. 11(a) is a front elevational cross sectional view and Fig. 11(b) is a plan view of a part thereof.
Fig. 12 shows a vacuum deposition device according to an embodiment of the present invention, in which Fig. 12(a) is a front elevational cross sectional view and Fig. 12(b) is a plan view of a part thereof.
Fig. 13 shows a control member in Fig. 12, in which Fig. 13 (a) is a cross sectional view as seen from a line A-A in Fig. 12(a), and Fig. 13(b) is a cross sectional view as seen from a line B-B in Fig. 12(a).
Fig. 14 is a principle view showing another structure of a carrier means.
Fig. 15 is a cross sectional view showing a prior art.

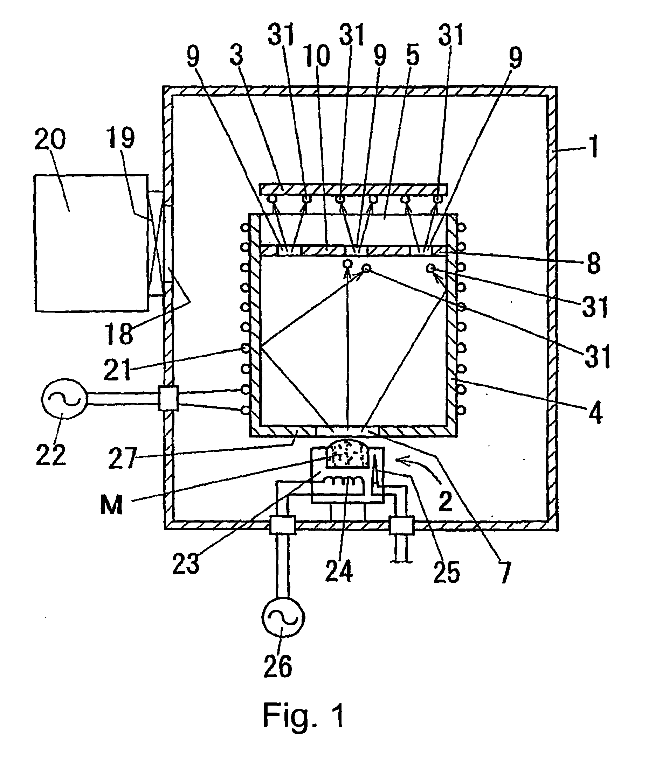

Fig. 1 shows a cross sectional view of a vacuum deposition device not covered by the present invention. A vacuum pump 20 is connected to an exhaust port 18 provided in a side surface of a vacuum chamber 1 via a gate valve 19. A tubular body 4 is arranged within the vacuum chamber 1. A heater 21 such as a sheath heater or the like is wound around an outer periphery of the tubular body 4, and the structure is made such that the tubular body 4 can be heated by feeding an electricity from a power source 22 connected to the heater 21 so as to make the heater 21 to generate heat.

Further, an evaporation source 2 is arranged in a lower side of the tubular body 4, within a lower portion of the vacuum chamber 1. A crucible 23, a heater 24 and a temperature sensor 25 are provided within the evaporation source 2, and the structure is made such that the evaporation source 2 is heated by feeding the electricity from a power source 26 connected to the heater 24 so as to make the heater 24 to generate heat, and the heat generation of the heater 24 can be controlled on the basis of a temperature detected by the temperature sensor 25.

The tubular body 4 is formed in an optional cross sectional shape such as a cylindrical shape, a rectangular tube shape and the like, however, is formed in a straight tube in the embodiment shown in Fig. 1. A collar piece 27 is extended to an inner periphery in a lower end of the tubular body 4, and an opening portion 7 is formed in an inner edge thereof so as to open by a small diameter, whereby the evaporation source 2 is set at a position just below the opening portion 7. Further, an opening portion 5 in an upper end of the tubular body 4 is formed so as to be open around an entire surface of an inner periphery of the tubular body 4.

Further, a control member 8 is provided in an inner portion of the tubular body 4. In the embodiment shown in Fig. 1, the control member 8 employs a structure formed by a plate member 10 in which through holes 9 are provided in a plurality of positions, and is arranged such that an outer periphery of the plate member 10 is bonded to an inner periphery of the tubular body 4 all around an entire periphery and the inner periphery of the tubular body 4 is closed by the plate member 10.

On the other hand an optional deposition material M can be employed, for example, an organic material such as an organic electroluminescent material or the like can be employed. Further, in order to carry out the deposition, the evaporation source 2 is set to a position just below the opening portion 7 in the lower end of the tubular body 4, the deposited body 3 is horizontally set so as to face to the opening portion 7 in an upper end of the tubular body 4, and the deposition material M is filled in the crucible 23. Next, an inner side of the vacuum chamber 1 is pressure reduced in a vacuum condition by operating the vacuum pump 20, the evaporation source 2 is heated by making the heater 24 to generate heat, and the tubular body 4 is heated by the heater 21. A heating temperature of the tubular body 4 is set to a temperature by which the substance vaporized from the evaporation source 2 is re-vaporized in accordance with an evaporation or the like even when the substance is attached to the tubular body 4, and is not accumulated on the surface of the tubular body 4.

When pressure reducing the inner side of the vacuum chamber 1 and heating the evaporation source 2 as mentioned above, the deposition material M is vaporized in accordance with a melting, an evaporation or a sublimation, and the vaporized substance 31 generated from the evaporation source 2 is introduced into the tubular body 4 from the opening portion 7 in the lower end and goes straight within the tubular body 4. Since a space between the evaporation source 2 and the deposited body 3 in which the vaporized substance 31 goes forward is surrounded by the tubular body 4, and a vaporized substance 31 is in a state of being closed within the tubular body 4, the vaporized substance 31 is reflected on the inner surface of the tubular body 4 and goes toward the opening portion 5 in the upper end as shown in Fig. 1. At this time, since the inner side of the tubular body 4 is closed by the plate member 10 constituting the control member 8, the vaporized substance 31 within the tubular body 4 passes through a through hole 9 provided in the plate member 10, thereafter comes out from the opening portion 5 in the upper end of the tubular body 4, and reaches the surface of the deposited body 3 arranged so as to face to the opening portion 5, whereby it is possible to accumulate the vaporized substance 31 on the surface of the deposited body 3 so as to achieve the deposition. As mentioned above, the vaporized substance 31 passes through the through holes 9 at a plurality of positions of the plate member 10 and goes toward the deposited body 3, and the vaporized substance 31 is introduced from each of the through holes 9 at a plurality of positions so as to reach the deposited body 3. Accordingly, the vaporized substance 31 can reach the deposited body 3 by a uniform distribution in comparison with the case that the vaporized substance 31 reaches the deposited body 3 from the evaporation source 2 at one position, it is possible to attach the vaporized substance 31 to the deposited body 3 by a uniform distribution and it is possible to apply the deposition to the deposited body 3 by a uniform film thickness.

In this case, tests are carried out by employing a square tube in which one line of an inner wall is 120 mm and a height is 280 mm, for the tubular body 4, setting the heating temperature to 200°C, employing tris (8-hydroxykinolynate) aluminum complex ("Alq3" produced by DOJINDO LABORATORIES) for the evaporation source 2, and vacuum depositing to the deposited body 3 constituted by a glass substrate of 100 mm × 100 mm × thickness 0.7 mm which is set horizontally at a distance of 300 mm from the evaporation source 2.

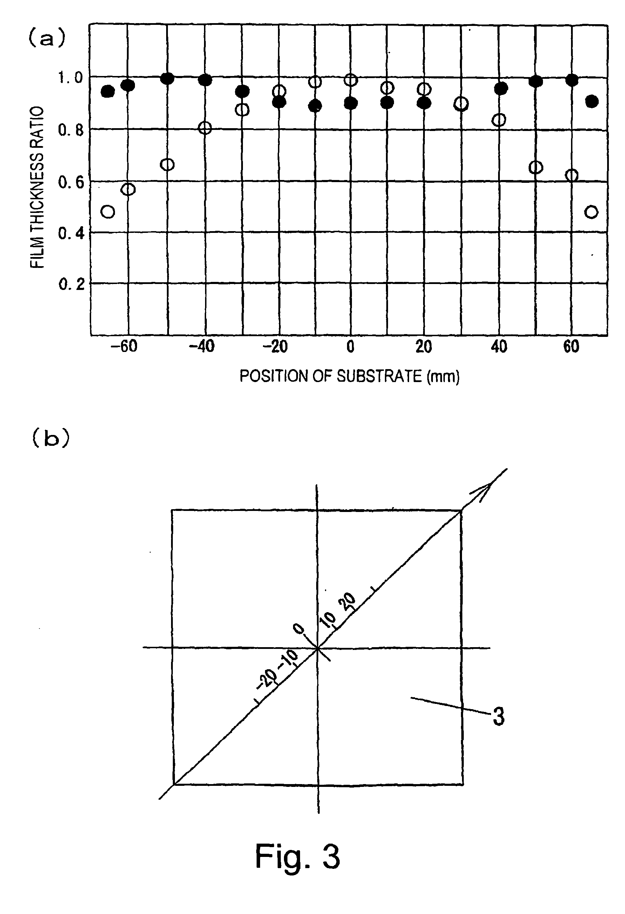

First, the test is carried out by employing the tubular body 4 provided with no control member 8. Results shown by a sign "○" in a graph in Fig. 3 (a) are obtained. The graph in Fig. 3 (a) displays a ratio by setting the center of the deposition surface of the deposited body 3 to "0", plotting points per 10 mm along a diagonal line from the center, measuring a film thickness of the deposition in each of the points and setting a film thickness of the center of the deposited body 3 to "1.0", as shown in Fig. 3 (b). As shown in the graph in Fig. 3(a), in the case that the vacuum deposition is carried out by using the tubular body 4 provided with no control member 8, the deposition film thickness is large in the center portion of the deposited body 3, and the deposition film thickness is small in the end portion of the deposited body 3. Accordingly, the film thickness is large and uneven.

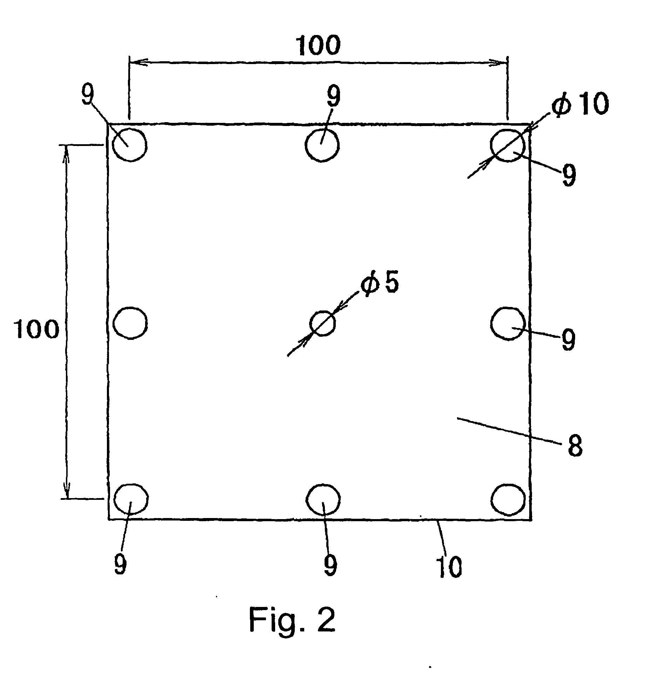

Next, as shown in Fig. 2, the deposition test is carried out by employing the control member 8 formed by arranging the through holes 9 having a diameter of 10 mm in eight positions at a uniform interval in the peripheral edge portion of the plate member 10 having a line of 120 mm and arranging the through hole 9 having a diameter of 5 mm in one position in the center, respectively, and placing the control member 8 at a position 250 mm apart from the evaporation source 2 and 50 mm apart from the deposited body 3 so as to mount to the inner side of the tubular body 4. Results are shown by "●" in the graph in Fig. 3(a). As shown in the graph in Fig. 3(a), the film thickness can be uniformized by carrying out the vacuum deposition with employing the tubular body 4 provided with the control member 8 with hardly changing the film thickness ratio of the deposition film thickness in the center portion and the end portion of the deposited body 3.

As is seen in the tests mentioned above, it is possible to obtain a high effect for uniformizing the film thickness of the deposition, by employing the plate member 10 formed by distributing the through holes 9 non-densely in correspondence to the portion in which the deposition film thickness of the deposited body 3 is large, and distributing the through holes 9 densely in correspondence to the portion in which the deposition film thickness of the deposited body 3 is small, for the control member 8. Further, in the case that the deposition is going to be applied to a predetermined position of the deposited body 3 at a large film thickness and to another predetermined position at a small film thickness, the vacuum deposition can be carried out in a state of setting the film thickness distribution intentionally, by employing the plate member 10 in which the through holes 9 are distributed densely in correspondence to the predetermined position and through holes 9 are distributed non-densely in correspondence to the other predetermined position, for the control member 8. In this case, the denseness and non-denseness in the distribution of the through holes 9 can be adjusted by changing a magnitude, a shape and the like of the through hole 9, in addition to the number of the through holes 9.

There is shown an example that an organic electroluminescent element is produced by the vacuum deposition apparatus having the structure as shown in Fig. 1.

A structure of the organic electroluminescent element employs 4,4'-bis[N-(naphthyl)-N-phenyl-amino]biphenyl ("α-NPD" produced by DOJINDO LABORATORIES) for a hole transport layer, Alq3 for a layer serving both as a light emitting layer and an electron transport layer, and LiF and Al for a cathode, and employs an ITO glass substrate of 100 m × 100 m × 0.7 mm as an anode.

The deposition device has three vacuum chambers, and is structured such that a space movement is of a rod handling type under a vacuum condition. The first and third chambers are structured only by the chamber and the evaporation source in the same manner as that of the conventional one. The second chamber is provided with a tubular body which is made of a stainless material (SUS316), is formed in a rectangular tube shape having one line dimension of 120 mm and a height of 280 mm and can be heated, within the chamber. The control member in Fig. 2 is provided in the second chamber. Further, a substrate is set at a distance 300 mm apart from the evaporation source, and the control member is positioned at a distance 250 mm. The present invention is applied to the second chamber because the second chamber is structured by the largest film thickness among the organic material layer, and an improved effect can be obtained.

α-NPD is deposited at a deposition speed of 1 to 2 Å/sec at a thickness of 400 Å in the first chamber, Alq3 is deposited at a heating temperature 240°C of the tubular body 4, at a deposition speed of 20 Å/sec at a thickness of 800 Å in the second chamber, thereafter, LiF is deposited at a deposition speed of 0.5 to 1.020 Å/sec at a thickness of 1000 Å in the third chamber, and subsequently Al is deposited at a deposition speed of 10 Å/sec at a thickness of 1000 Å, under the reduced pressure of 1 × 10⁻⁶ Torr (1.33 × 10⁻⁴ Pa), by using the evaporation device. It is possible to confirm homogeneity having a size 100 mm × 100 mm and having no dispersion of brightness in place, by sealing the obtained organic electroluminescent, and mounting an electrode for applying an electricity. In this case, an unevenness in brightness is generated in the organic electroluminescent element produced by using the heating tubular body provided with no control member 8 in the second chamber, in the case of comparing the center portion with the peripheral portion of the substrate.

As mentioned above, the vaporized material 31 vaporized from the evaporation source 2 is controlled within the tubular body 4, it is possible to prevent the vaporized substance 31 from being dispersed in all directions, and it is possible to make most of the vaporized substance 31 vaporized from the evaporation source 2 to reach the surface of the deposited body 3 so as to attach thereto. Accordingly, most of the vaporized material 31 vaporized from the evaporation source 2 is attached to the surface of the deposited body 3 so as to contribute to a film formation, whereby an ineffective material is reduced, and a material use efficiency of the deposition material M becomes high, so that it is possible to carry out the deposition at a high yield ratio, and it is possible to make a film forming speed on the surface of the deposited body 3. Further, since the tubular body 4 is heated and constitutes a hot wall, even in the case that the vaporized substance 31 is attached to the surface of the tubular body 4, the attached substance is re-heated in the tubular body 4 so as to be vaporized. Further, the plate member 10 mounted so as to be in contact with the inner periphery of the tubular body 4 is heated by a heat transfer from the tubular body 4 and a radiant heat, the substance vaporized from the evaporation source 2 is vaporized in accordance with a re-evaporation or the like even when the substance is attached to the plate member 10, and the vaporized substance 31 re-vaporized from the tubular body 4 and the plate member 10 is deposited to the surface of the deposited body 3 in the same manner as mentioned above. Therefore, it is possible to prevent the vaporized substance 31 from being accumulated on the plate member 10 forming the tubular body 4 and the control member 8 and from being unusable, so that the yield ratio of the deposition is not lowered. In this case, in the case that the heating is insufficient only by the heat transfer from the tubular body 4 and the radiant heat such as the case that the size of the plate member 10 is large and the like, it is desirable to heat by adding a heater to the plate member 10.

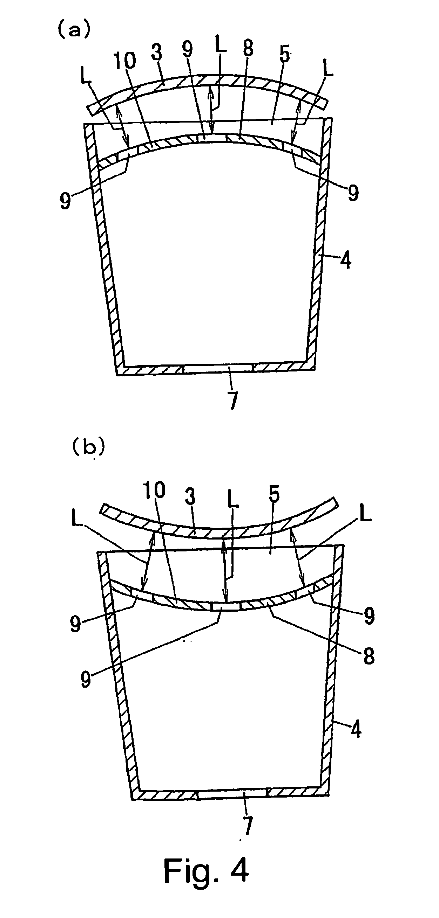

Fig. 4 shows another vacuum deposition device not covered by the invention. The structure is made such that a deposition surface serving as the deposited body 3 has a curved surface, and a shape of the plate member 10 constituting the control member 8 is formed so as to have a curved shape corresponding to the curved surface of the deposited body 3. For example, in the case that the deposition surface serving as the deposited body 3 is formed in a concave curved surface as shown in Fig. 4(a), the plate member 10 in which the surface in the side of the deposited body 3 is formed in a convex curved surface is employed. Further, in the case that the deposition surface serving as the deposited body 3 is formed in a convex curved surface as shown in Fig. 4 (b), the plate member 10 in which the surface in the side of the deposited body 3 is formed in a concave curved surface is employed. The other structures are the same as those in Fig. 1. Further, it is possible to uniformly make the vaporized substance 31 to reach the surface of the deposited body 3 from each of the through holes 9 provided in the plate member 10 by forming the shape of the plate member 10 constituting the control member 8 in the curved shape corresponding to the curved surface of the deposited body 3 in the manner mentioned above, even in the case that the deposited body 3 has the curved surface, whereby it is easy to carry out the vacuum deposition at a uniform film thickness.

Further, it is possible to arrange the plate member 10 constituting the control member 8 within the tubular body 4 in such a manner as to be parallel to the deposition surface of the deposited body 3 which is set so as to face to the opening portion 5 of the tubular body 4. A distance L between each of the portions of the plate member 10 and each of the opposing portions of the deposition surface of the deposited body 4 becomes uniform as shown in Fig. 4 by arranging the plate member 4 of the control member 8 in parallel to the deposition surface of the deposited body 3 as mentioned above, and it is easy to carry out the vacuum deposition at a uniform film thickness.

In the case of forming the tubular body 4 in a straight tube as mentioned above so as to open the opening portion 5 to the perpendicularly upper side, the deposited body 3 arranged so as to face to the opening portion 5 is set in a horizontal attitude. However, in the case of setting the deposited body 3 in a horizontally arranged attitude, the lower surface of the deposited body 3 corresponds to the surface to which the deposition is applied, and can not be supported. Accordingly, there is a risk that the lower surface of the deposited body 3 is deflected in a center portion due to its own weight in accordance with an application of the gravity as shown by a chain line in Fig. 15 so as to be deformed. In the case of employing the thin plate shape structure for the deposited body 3, the center portion is deflected due to its own weight and the deformation bending to protrude to the lower side tends to be generated. In particular, the plate-shaped structure having a large size tends to have a great deformation. In the case that the deposition is applied to the deposited body 3 which is deflected and deformed due to its own weight, the vaporized substance tends to be attached to the portion protruding to the evaporation source 2 in the surface of the deposited body 3. Accordingly, the thickness of the film vaporized to the surface of the deposited body 3 becomes uneven, and there is a risk that a quality of the deposition is unstable.

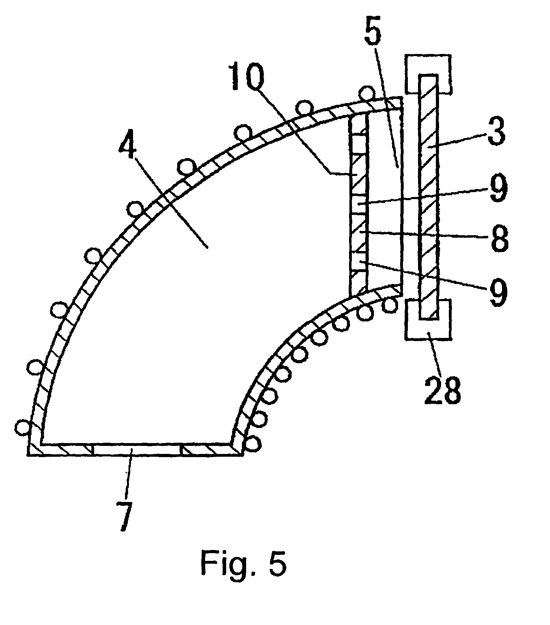

Accordingly, in the embodiment shown in Fig. 5, the tubular body 4 is bent at right angles so as to be formed as an L-shaped tube. The tubular body 4 formed by bending in the L shape is arranged such that the lower portion is oriented in a vertical direction and the upper portion is oriented in a horizontal direction, and is structured such that the opening portion 7 in the lower end of the tubular body 4 is open to the lower side, and the opening portion 5 in the upper end of the tubular body 4 is open to the horizontal direction. The structure is made such that the vacuum source 2 is set to a position just below the opening portion 7 in the lower end of the tubular body 4, the control member 8 is provided within the portion near the opening portion 5 in the upper end of the tubular body 4, and the opening end surface of the opening portion 5 is formed as a vertical surface. Further, the deposited body 3 is set such that the surface thereof is arranged so as to face in parallel to the opening portion 5, and in the case that the plate-shaped substrate is used as the deposited body 3, the deposited body 3 is arranged in a vertically rising attitude. In the embodiment shown in Fig. 5, the structure is made such that the deposited body 3 is supported in a vertical state by holding the upper end edge and the lower end edge (or four peripheral end edges) of the deposited body 3 by a supporting body 28. The other structures are the same as those of Fig. 1.

Further, since the deposited body 3 is arranged in the vertical attitude in the case of carrying out the deposition in the manner mentioned above, the deposited body 3 is not deformed due to the application of the gravity, so that it is possible to prevent the surface of the deposited body 3 opposing to the opening portion 5 of the tubular body 4 from being deformed. Accordingly, it is easy to uniformize the thickness of the film deposited to the surface of the deposited body 3 while preventing the deposition from being deflected due to the deformation of the surface of the deposited body 3, so that the quality of the deposition is stabilized.

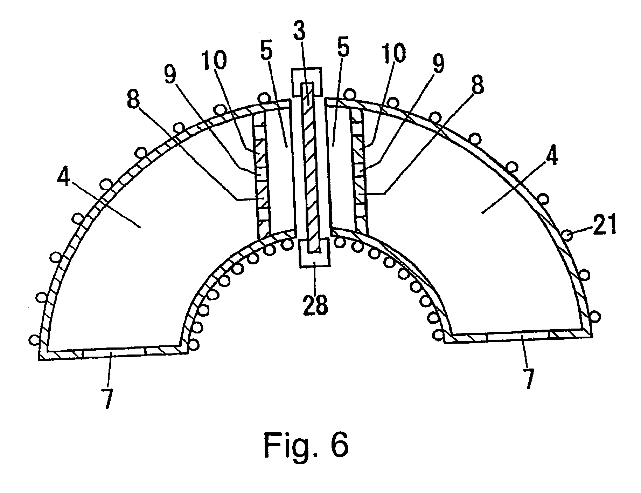

In an embodiment shown in Fig. 6, a pair of tubular bodies 4 formed as the L-shaped tube obtained by perpendicularly bending in the manner mentioned above are employed, a pair of tubular bodies 4 and 4 are opposed to each other in the respective upper end opening portions 5 and 5 at a predetermined interval, and a pair of tubular bodies 4 and 4 are arranged within the vacuum chamber 1 in this state. The other structures are the same as those in Fig. 1, and the evaporation source 2 is arranged just below each of a pair of tubular bodies 4 and 4. Further, the deposited body 3 is arranged and set between the opening portions 5 and 5 of the tubular bodies 4 and 4 in such a manner that the surfaces in both sides face in parallel to the opening portions 5 and 5 of the respective tubular bodies 4 and 4. In the case of using the plate-shaped substrate for the deposited body 3, the deposited body 3 is arranged in the vertically rising attitude, and the deposited body 3 is supported in the vertical state by holding the upper end edge and the lower end edge (or four peripheral end edges) of the deposited body 3 by the supporting body 28.

In the structure in accordance with the embodiment, when setting the evaporation source 2 just below each of a pair of tubular bodies 4 and 4, pressure reducing the inner side of the vacuum chamber 1 and heating each of the evaporation sources 2, the vaporized material 31 vaporized from the evaporation source 2 is introduced to each of the tubular bodies 4 and 4 from the lower end opening portions 7 and 7, and reaches each of the surfaces in both sides of the deposited body 3 from each of the opening portions 5 and 5 in the upper end after passing through the inner side of each of the tubular bodies 4 and 4 while reflecting on the inner surface, whereby it is possible to simultaneously apply the deposition to both surfaces of the deposited body 3. Accordingly, it is possible to improve a productivity of the deposition process, and it is possible to form the different deposition films on both surfaces of the deposited body 3 by using the different evaporation sources 2 for the evaporation sources 2 set to a pair of tubular bodies 4 and 4. In the case of using the deposited body obtained by laminating two substrates for the deposited body 3, it is possible to simultaneously apply the deposition to the surfaces of two substrates.

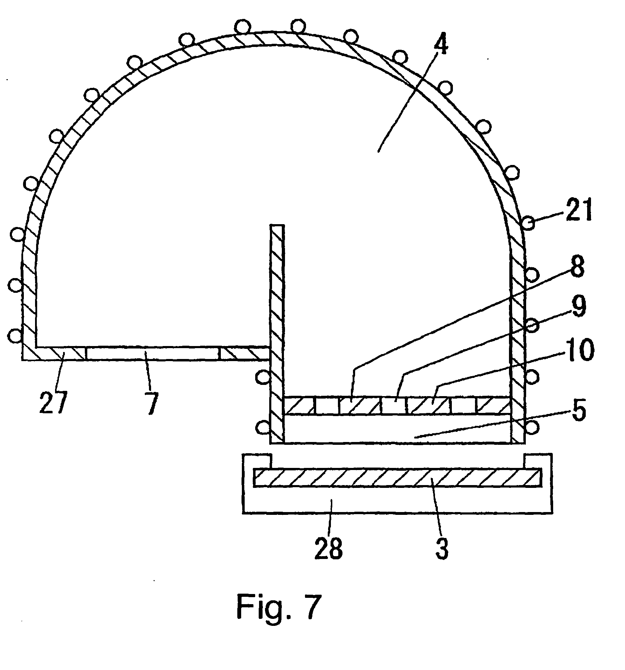

In an embodiment shown in Fig. 7, the tubular body 4 employs a U-shaped tube obtained by being bent in an inverse U shape at an angle of 180 degree. The tubular body 4 formed by bending in the inverse U shape is arranged within the vacuum chamber 1 such that the opening portions 5 and 7 in both ends are open toward a lower side. A collar piece 27 is extended out to an inner periphery in one end of the tubular body 4, the opening portion 7 is formed in an inner edge thereof so as to be open at a small diameter, and the evaporation source 2 is set at a position just below the opening portion 7. Further, the opening portion 5 in another end of the tubular body 4 is structured such as to be widely open around an entire surface of the inner periphery of the tubular body 4, an opening end surface thereof is formed in a horizontal surface, and the opening portion 5 is formed so as to be positioned in a lower side than the opening portion 7 in another end. The control member 8 is provided within a position near the opening portion 5. Further, the deposited body 3 is arranged and set such that the upper surface thereof is faced in parallel to the opening portion 5, and in the case that the plate-shaped substrate is employed for the deposited body 3, the deposited body 3 is arranged in a horizontally laid attitude. Since it is possible to arrange the deposited body 3 in the horizontal attitude with setting the surface to be deposited to the upper surface, the deposited body 3 can be supported in a state in which the lower surface of the deposited body is held by the supporting body 28. The other structures are the same as those in Fig. 1.

In the structure in accordance with the embodiment, when pressure reducing the inner side of the vacuum chamber 1 and heating the evaporation source 2, the vaporized substance 31 vaporized from the evaporation source 2 is introduced to the tubular body 4 from the lower end opening portion 7 and reaches the upper surface of the deposited body 3 from the opening portion 5 after passing through the inner side of the tubular body 4 while reflecting on the inner surface thereof, whereby it is possible to apply the deposition to the upper surface of the deposited body 3. In this case, since the deposited body 3 is horizontally arranged in a state in which an entire surface of the lower surface is supported, the deposited body 3 is not deformed due to the application of the gravity, so that it is possible to prevent the surface of the deposited body 3 opposing to the opening portion 5 of the tubular body 4 from being deformed. Accordingly, it is easy to uniformize the film thickness deposited to the surface of the deposited body 3 while preventing the deposition from being deflected due to the deformation of the surface of the deposited body 3, and the quality of the deposition is stabilized. Further, in the structure mentioned above, it is possible to set the set position of the evaporation source 2 and the set position of the deposited body 3 to places which are close to each other, and it is possible to simultaneously carry out a work for supplying the evaporation source 2 and a work for replacing the deposited body 3.

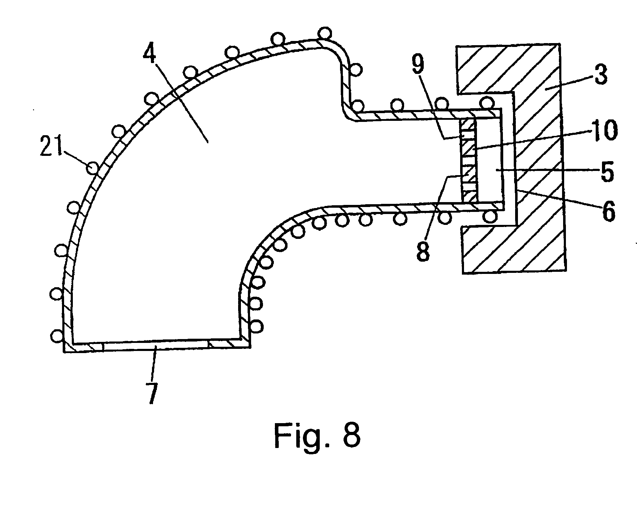

Fig. 8 shows another part of a vacuum deposition device not covered by the present invention. In this structure, a deposited body having a recess portion 6 is employed for the deposited body 3, and the deposition can be applied to the recess portion 6. In other words, the opening portion 5 in the leading end of the tubular body 4 is formed in a shape which is suitable for being inserted to the recess portion 6 of the deposited body 3, and the tubular body 4 in which the opening portion 5 is formed in this manner is arranged within the vacuum chamber 1. In the embodiment shown in Fig. 8, the tubular body which is bent at right angles and is formed as an L-shaped tube as shown in Fig. 1 is employed for the tubular body 4, the leading portion of the tubular body 4 is narrowed so as to make the diameter of the opening portion 5 small, and the opening portion 5 is formed in a diameter capable of being inserted to the recess portion 6 of the deposited body 3. The control member 8 is provided within a portion near the opening portion 5. The other structures are the same as those in Fig. 1.

In the structure in accordance with the embodiment, when setting the deposited body 3 in a state in which the opening portion 5 of the tubular body 4 is inserted to the recess portion 6, pressure reducing the inner side of the vacuum chamber 1 and heating the evaporation source 2, the vaporized substance 31 vaporized from the evaporation source 2 is introduced to the tubular body 4 from the lower end opening portion 7, is discharged from the opening portion 5 after passing through the inner side of the tubular body 4 while reflecting on the inner surface thereof, and reaches the inner surface of the recess portion 6 of the deposited body 3, whereby it is possible to apply the deposition to the inner surface of a position in which it is very hard to apply the deposition, such as the recess portion 6 of the deposited body 3.

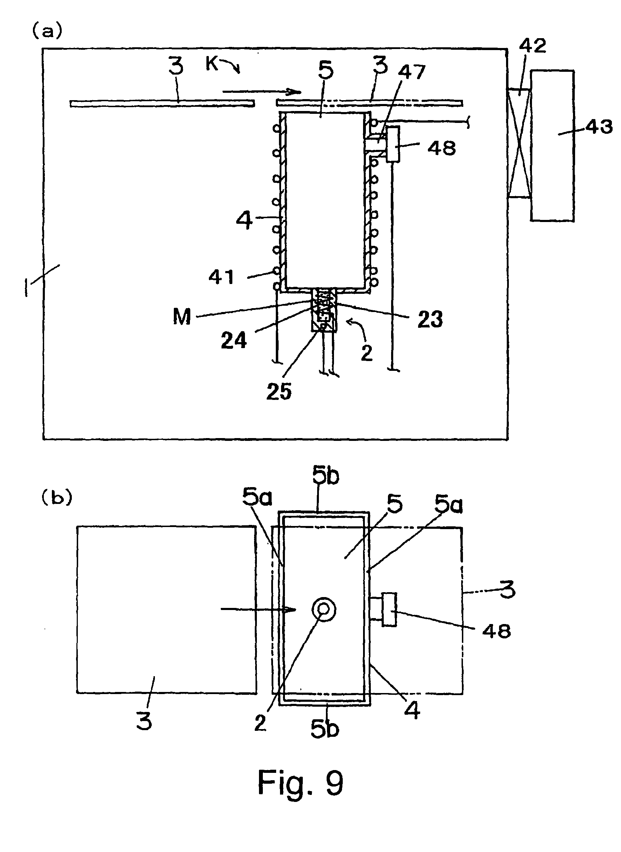

Fig. 9 shows another vacuum deposition device not covered by the present invention. A vacuum pump 43 is connected to a side surface of the vacuum chamber 1 via a gate valve 42. The tubular body 4 is arranged within the vacuum chamber 1. The tubular body 4 is formed in a square tube shape in which an upper surface constitutes the opening portion 5, and a heater 41 such as a sheath heater or the like is wound around an outer periphery thereof, whereby it is possible to heat the tubular body 4. The evaporation source 2 is fitted and mounted to a center portion of a bottom surface in the tubular body 4, and a deposition material M is filled in a crucible 23 of the evaporation source 2. A heater 24 for heating the deposition material M is built in the evaporation source 2, and the heating temperature can be detected by a temperature sensor 25 formed by a thermo couple or the like. Further, a side opening portion 47 is formed in a side wall of the tubular body 4, and a film thickness meter 48 is mounted so as to face to an inner side of the side opening portion 47. The film thickness meter 48 is formed by a quartz oscillator film thickness meter or the like, and can automatically measure the film thickness of the film deposited and attached to the surface.

In this case, in the tubular body 4 formed in the square tube shape, the opening portion 5 in the upper end thereof is formed in a rectangular shape (an oblong rectangular shape) having a long line 5a and a short line 5b. The deposited body 3 formed by the glass substrate or the like is generally formed in an approximately square shape, the long line 5a of the opening portion 5 is formed longer than one line of the deposited body 3, and the short line 5b of the opening portion 5 is formed shorted than one line of the deposited body 3. It is preferable that the short line 5b of the opening portion 5 is about one half to one quarter of the long line 5a. Even in the case that the deposited body 3 employs a structure in which one line is equal to or more than 200 mm (preferably equal to or more than 300 mm, practically 1 m although an upper limit does not exist) and an area is great, an area of the opening portion 5 can be formed about one half to one quarter of the deposited body 3.

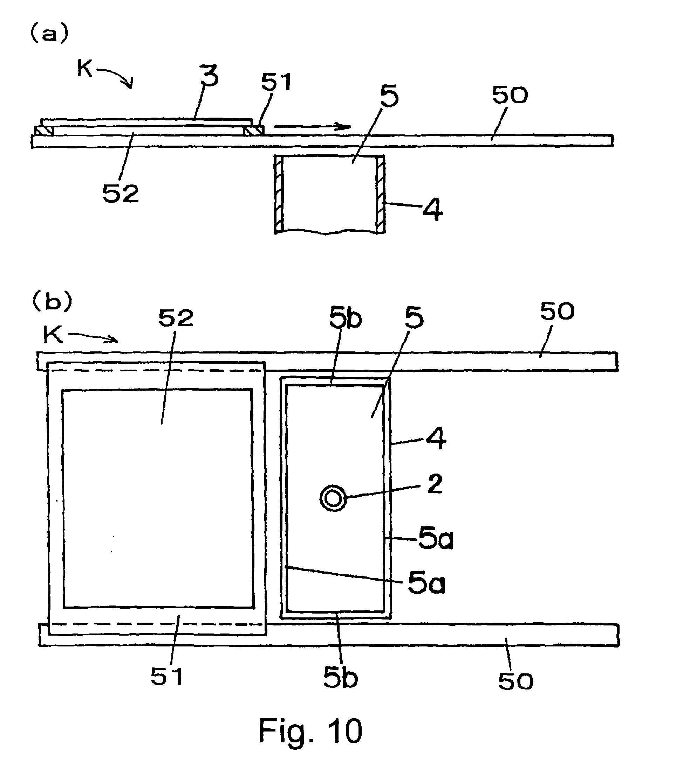

Further, a carrier means K corresponding to a means for carrying the deposited body 3 horizontally is provided above the tubular body 4. The carrier means K is, for example, as shown in Fig. 10, formed by a pair of horizontally arranged carrier rails 50 and a carrier jig 51, each of the carrier rails 50 is arranged so as to come across a near edge of the tubular body 4 from one side of the tubular body 4 and reach another side of the tubular body 4 as shown in Fig. 10(b) (a drawing obtained by seeing Fig. 10(a) from the above), and the carrier jig 51 is provided so as to bridge between a pair of carrier rails 50 and 50. The carrier jig 51 is provided with a depositing opening portion 52 at a position between the carrier rails 50 and 50 so as to be formed in a frame shape, and is structured such as to move along the carrier rail 50 in a range from one side of the tubular body 4 to another side of the tubular body 4 across the upper side of the opening portion 5 of the tubular body 4. The deposited body 3 formed by the glass plate or the like is mounted and set on the carrier jig 51 as shown in Fig. 10 (a) in a state in which the lower surface of the deposited body 3 is faced to the depositing opening portion 52, whereby the deposition can be carried out at a time of moving the carrier jig 51 from the side position of the tubular body 4 to the position just above the opening portion 5 of the tubular body 4. In other words, the vacuum deposition device shown in Fig. 9 is structured such that the opening portion of the tubular body 4 is formed in the rectangular shape constituted by the long line 5a and the short line 5b, and the vacuum deposition device is provided with the carrier means K for moving the deposited body 3 having the magnitude that the length of the line extending along the long line 5a is shorter than the length of the long line 5a and the length of the line extending along the short line 5b is longer than the length of the short line 5b in the direction parallel to the short line 5b so as to come across the opening portion 5.

Accordingly, in the case of using the vacuum deposition device formed in the manner mentioned above and depositing the deposition material M to the deposited body 3 such as the glass substrate or the like, first, the inner side of the vacuum chamber 1 is pressure reduced to the vacuum state by operating the vacuum pump 43, and the tubular body 4 is heated by generating heat by the heater 41. The heating temperature of the tubular body 4 is set to a temperature by which the vaporized substance 31 from the evaporation source 2 is re-vaporized even when it is attached to the inner surface of the tubular body 4, and is not accumulated on the inner surface of the tubular body 4. Further, the deposition material M within the evaporation source 2 is vaporized by heating the heater 24 and the vaporized substance is dispersed within the tubular body 4.

Further, the deposited body 3 is mounted on the carrier jig 51 as shown in Fig. 10(a), and the carrier jig 51 is moved along the carrier rail 50, whereby the deposited body 3 is moved from one side position of the tubular body 4 to the position just above the opening portion 5 of the tubular body 4 so as to be from a solid line position in Figs. 9 (a) and 9(b) to a chain line position, and the deposited body 3 is moved to another side position of the tubular body 4 by passing through the position just above the opening portion 5. At a time of passing the deposited body 3 across the position just above the opening portion 5 as mentioned above, the vaporized substance 31 from the crucible 23 is attached to the lower surface opposing to the opening portion 5 of the deposited body 3 through the opening portion 5, whereby the deposition can be achieved by accumulating the vaporized substance 31 on the lower surface of the deposited body 3. The film thickness of the deposition can be adjusted in correspondence to the number of passing across the opening portion 5, by carrying out the deposition by moving the deposited body 3 across the opening portion 5 of the tubular body 4. In addition to carrying the deposited body 3 in one direction so as to come across the opening portion 5, it is possible to move the deposited body 3 across the opening portion 5 by carrying in a reciprocating direction or carrying in a reciprocating direction at a plurality of times.

At this time, the deposited body 3 is structured such as to move in a direction parallel to the short line 5b of the opening portion 5 at a position within a range of the long line 5a of the opening portion 5 in the tubular body 4 so as to pass across the position just above the opening portion 5, and an entire surface of the lower surface in the deposited body 3 comes across the position just above the opening portion 5, so that it is possible to deposit the vaporized substance to the entire surface of the lower surface in the deposited body 3. In this case, even in the case that the deposited body 3 has a great area in which one line is equal to or more than 200 mm, it is possible to form the area of the opening portion 5 smaller by forming the opening portion 5 of the tubular body 4 in the rectangular shape constituted by the long line 5a and the short line 5b as mentioned above, and a difference in concentration is small between the center portion and the peripheral portion at a time when the vaporized substance 31 from the evaporation source 2 within the base portion of the tubular body 4 passes through the opening portion 5. Accordingly, the vaporized substance 31 is deposited to the entire surface of the deposited body 3 at.a uniform concentration, and it is possible to carry out the deposition at a uniform film thickness.

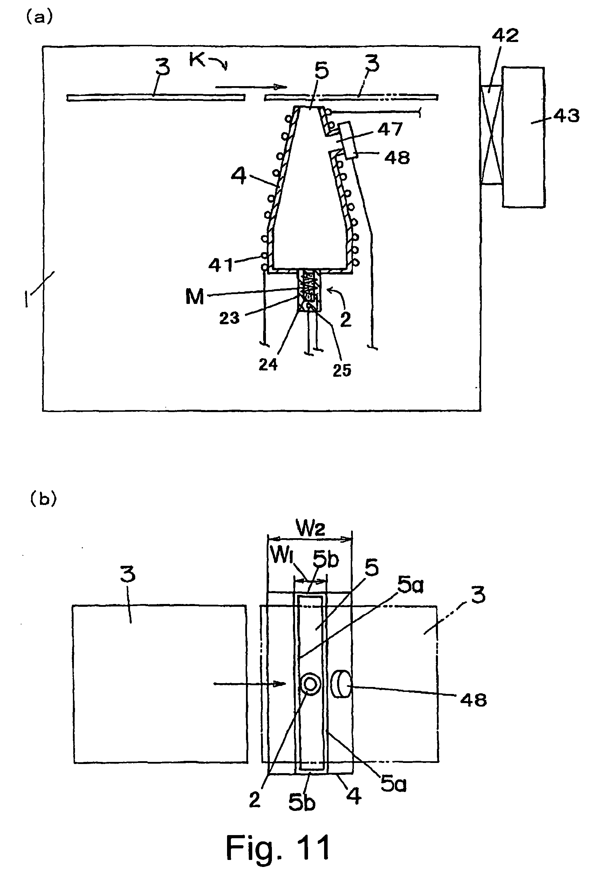

Fig. 11 shows the other embodiment of the vacuum deposition device shown in Fig. 9. In the embodiment shown in Fig. 9, the tubular body 4 is formed in the straight shape having the same inner diameter from the base portion to the upper end opening portion 5, however, in the embodiment shown in Fig. 11, the structure is made such that the dimension of the short line 5b of the opening portion 5 in the upper end of the tubular body 4 is made smaller than the dimension of the base portion of the tubular body 4 in which the evaporation source 2 is set, and the area of the opening portion 5 is made smaller than the area of the base portion of the tubular body 4. It is preferable that a dimension W1 of the short line 5b of the opening portion 5 is about one half to one quarter of a width W2 of the base portion of the tubular body 4, by which no influence is applied to a resistance of a flow along which the evaporation substance flies. The dimension of the long line 5a of the opening portion 5 is equal to the dimension of the base portion of the tubular body 4. Accordingly, the upper portion of the tubular body 4 is formed in a shape that an inner diameter is narrowed such that the surface close to the long line 5a is inclined to a diagonally upper side toward an inner side. The other structures such as the carrier means K and the like are the same as those in Figs. 9 and 10.

In the structure shown in Fig. 11, the opening area of the opening portion 5 is made smaller by making the dimension of the short line 5b of the opening portion 5 in the upper end of the tubular body 4 smaller than the dimension of the base portion of the tubular body 4 as mentioned above. Accordingly, in the heated tubular body 4, the radiant heat is radiated to the upper side from the inner wall of the tubular body 4 through the opening portion 5, however, it is possible to reduce the radiation of the radiant heat by making the opening area of the opening portion 5 smaller, it is possible to restrict the deposited body 3 from being heated by the radiant heat, and it is possible to prevent the temperature of the deposited body 3 from being heated to an evaporation temperature and a decomposition temperature of the deposition material M, whereby a deposition efficiency is reduced.

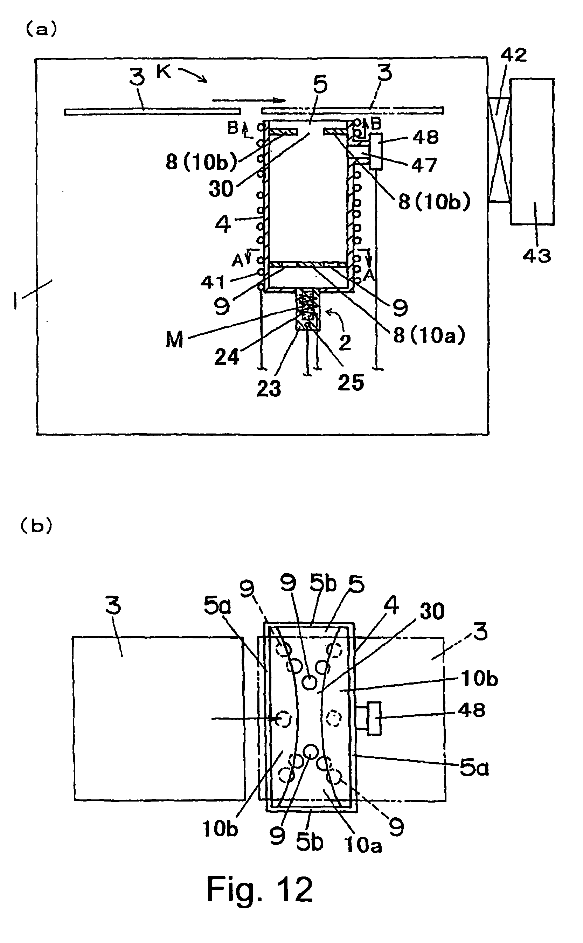

Fig. 12 shows an embodiment of a vacuum deposition device according to the invention. The control member 8 is provided in each of upper and lower sides of the tubular body 4 in order to control the flying path of the vaporized substance at a time when the vaporized substance from the evaporation source 2 flies and moves to the side of the opening portion 5 within the tubular body 4, between the evaporation source 2 set in the bottom portion of the tubular body 4 and the opening portion 5 in the upper end of the tubular body 4. In other words, the control member 8 employs a porous plate 10a arranged just above the evaporation source 2, and an obstacle plate 10b arranged just below the opening portion 5.

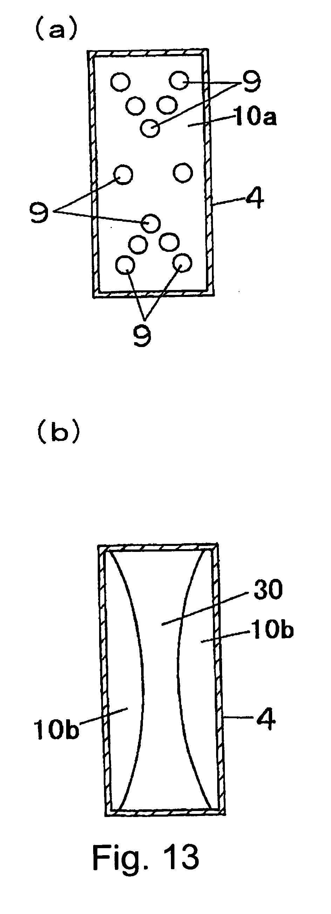

The porous plate 10a is provided with a lot of through holes 9 so as to be distributed more in a peripheral portion than in a center portion, as shown in Fig. 13 (a), and is mounted to the inner surface of the tubular body 4 so as to section an inner side of the lower end portion of the tubular body 4 into upper and lower sides. Further, a pair of obstacle plates 10b are provided so as to protrude in opposition to the respective inner surfaces of the opening portion 5 in the side of the long line 5a, as shown in Fig. 13 (b), and a gap 30 is formed between opposing leading ends of the obstacle plates 10b and 10b. Further, the leading end edge of each of the obstacle plates 10b is formed so as to protrude more in the center portion, whereby a width of the gap between the leading ends of the obstacle plates 10b and 10b is narrower in the center portion along the long line 5a of the opening portion 5 and is wider in the end portion. The other structures are the same as those in Figs. 9 to 11.

In the structure shown in Fig. 12, the evaporation source 2 is fitted and mounted to the center portion of the bottom surface in the tubular body 4, and the deposition material M is filled in the crucible 23. The heater 24 for heating the deposition material M is built in the crucible 23, and the heating temperature can be detected by the temperature sensor 25 formed by the thermo couple or the like. Since the evaporation source 2 is set to the center portion of the bottom portion of the tubular body 4, the vaporized substance 31 from the evaporation source 2 flies on the basis of the evaporation source in the center portion of the bottom portion of the tubular body 4, however, is blocked by the porous plate 10a provided just above the evaporation source 2, passes through each of a lot of through holes 9 provided in the porous plate 10a, and flies to an upper side of the porous plate 10a. In this case, since the through holes 9 are provided so as to be distributed more in the peripheral portion than in the center portion, it is possible to inhibit the vaporized substance 31 from being linearly discharged from the crucible 23 so as to go toward the deposited body 3 as it is. Further, the flying vaporized substance 31 is blocked by the obstacle 10b, and flies to the upper side through the gap 30 between the obstacle plates 10b, however, since the gap 30 is formed so as to be narrower in the center portion along the long line 5a of the opening portion 5 and wider in the end portion, the vaporized substance passes through the gap 30 while being widened toward the end portion. In the manner mentioned above, it is possible to prevent the concentration of the vaporized substance 31 from being higher in the center portion of the opening portion 5 and lower in the peripheral portion, whereby it is possible to make the concentration of the vaporized substance 31 passing through the opening portion 5 uniform in an entire surface of the opening portion 5, and it is possible to further uniformize the film thickness of the deposition to the deposited body 3.

Although drawings for exclusive use are omitted, a vacuum deposition device may employ only the obstacle plate 11 arranged just below the opening portion 5 in the upper end lower control members 8 (refer to Fig. 13(b)), in the device shown in Fig. 12. In accordance with a specific structure, the tubular body 4 employs a structure which is made of a stainless steel material (SUS316), has a dimension 420 mm × 120 mm × height 230 mm, and is formed by winding a sheath heater around an outer wall, and the evaporation source 2 constituted by the crucible 23, the heater 24 and the temperature sensor 25 is fitted to the center of the bottom portion of the tubular body 4. The deposition material M employs Alq3, and is filled in the crucible 23, and the deposited body 3 employs the glass substrate of 400 mm × 200 mm × thickness 0.7 mm.

Further, the deposition material M is heated by an electric power of a voltage 20 volt and a current 0.4 ampere so as to make the deposited body 3 standby, and if the rate within the tubular body 4 heated at 240°C becomes stable, the deposited body 3 is carried in the direction parallel to the short line 5b of the tubular body 4 at a speed about 100 mm/min by an appropriate carrier means K. As a result of carrying out the deposition by using the vacuum deposition device, it is possible to obtain an effect that the film thickness distribution of the deposition layer in the deposited body 3 is improved to ± 5 % or less from ± 28 % in the case that no obstacle plate is provided. In this case, the number of the control member 8 may be set to one (singular number) as mentioned here, or may be set to two or more (plural number) as shown in Fig. 12.

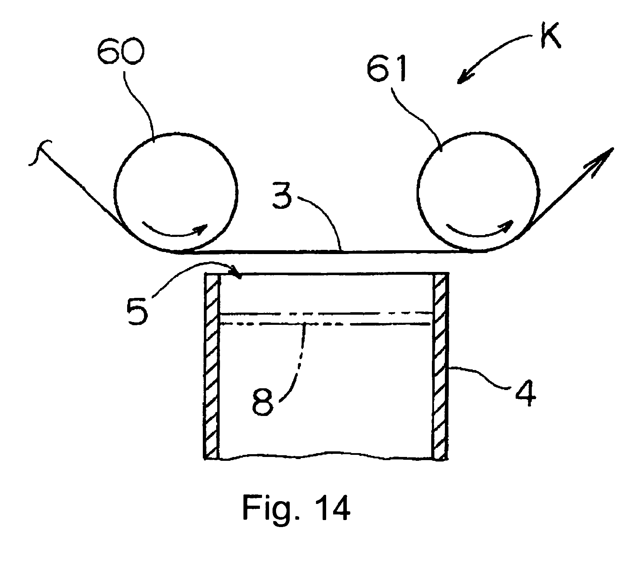

Fig. 14 shows the other embodiment of the carrier means K. This embodiment is structured as the carrier means K for moving across the opening portion 5 by winding a film sheet deposited body 3 unwound from a unwinding roller (not shown) to a take-up roller (not shown) after passing through a pair of rolling rollers 60 and 61 having the same diameter and arranged at the same height level. Since the opening portion 5 and the deposited body 3 are arranged so as to oppose in parallel to each other in the upper position of the tubular body 4 by building the deposited body 3 in a tensional state between two rolling rollers 60 and 61, there is obtained an advantage that a uniform and good deposition state can be continuously obtained in comparison with, for example, a means that the deposited body 3 is arranged in the upper side of the opening portion 5 in a state of being wound around a single large-diameter rolling roller.

Further, an organic electroluminescent element may be produced by depositing an organic electroluminescent material as the deposition material M to the film sheet deposited body 3, by using the vacuum deposition device (or the vacuum deposition method) having the carrier means K shown in Fig. 1 or 14. The other organic material may be set as the deposition material M.

### DESCRIPTION OF REFERENCE NUMERALS

- 1: vacuum chamber
- 2: evaporation source
- 3: deposited body
- 4: tubular body
- 5: opening portion
- 5a: long line
- 5b: short line
- 6: recess portion
- 8: control member
- 9: through hole
- 10: plate member
- 10a: porous plate
- 10b: obstacle plate
- 11: heater
- 23: crucible
- 24: heater
- 25: temperature sensor
- 30: gap
- 31: vaporized substance
- K: carrier means

## Claims

1. A vacuum deposition device in which an evaporation source (2) and a deposited body (3) are arranged within a vacuum chamber (1), a space between the evaporation source (2) and the deposited body (3) is surrounded by a tubular body (4) heated at a temperature by which a substance of the evaporation source (2) is vaporized, and the substance vaporized from the evaporation source (2) is made to reach a surface of the deposited body (3) through an inner side of the tubular body (4) so as to be deposited, wherein a control member (8) for controlling so as to guide a movement of said vaporized substance toward the deposited body (3) within said tubular body (4) is provided within said tubular body (4), wherein, an opening portion (5) of the tubular body (4) is formed in a rectangular shape constituted by a long line (5a) and a short line (5b), and the vacuum deposition device is provided with a means for moving the deposited body (3), said means for moving having a magnitude that the length of a line extending along said long line (5a) is shorter than the length of said long line (5a), and the length of a line extending along said short line (5b) is longer than the length of said short line (5b) in a direction parallel to said short line (5b) so as to come across said opening portion (5),
**characterized in that**
said control member (8) is a pair of obstacle plates (10b) which are arranged in a side close to the opening portion (5) and are provided so as to protrude in opposition to respective inner surfaces close to the long lines (5a) of the opening portion (5), and a width of a gap (30) between the respective leading ends of the obstacle plates (10b) becomes narrower toward the center portion of the long line (5a) in the opening portion (5) and wider toward the end portion.

2. The vacuum deposition device according to claim 1, wherein said control member (8) also includes a porous plate (10a) which is arranged in a side close to the evaporation source (2) and is provided with a plurality through holes (9) passing the substance evaporated from the evaporation source (2) therethrough.

3. The vacuum deposition device according to claim 2, wherein the density of the plurality of through holes (9) is high at one specific area of the control member (8) and low at another specific area.

4. The vacuum deposition device according to claim 3, wherein the through holes (9) are distributed more in a peripheral portion than in a center portion of the porous plate (10a).

5. The vacuum deposition device according to claim 1, wherein the control member (8) is arranged so as to be approximately parallel to the surface to which the deposition material is deposited.

6. The vacuum deposition device according to claim 1, wherein the control member (8) is heated up to a temperature by which the substance of the evaporation source (2) is vaporized.

7. The vacuum deposition device according to claim 1, wherein the deposited body (3) is formed as a plate member having an approximately square shape in which each of lines is equal to or more than 200 mm.

## Patentansprüche

1. Vorrichtung zur Vakuumabscheidung, bei der eine Verdampfungsquelle (2) und ein Abscheidungskörper (3) innerhalb einer Vakuumkammer (1) angeordnet sind, ein Raum zwischen der Verdampfungsquelle (2) und dem Abscheidungskörper (3) von einem rohrförmigen Körper (4) umgeben ist, der auf eine Temperatur, bei der eine Substanz der Verdampfungsquelle (2) verdampft wird, erwärmt ist, und die von der Verdampfungsquelle (2) verdampfte Substanz eine Oberfläche des Verdampfungskörpers (3) durch das Innere des rohrförmigen Körpers (4) erreicht, um abgeschieden zu werden, wobei innerhalb des rohrförmigen Körpers (4) ein Steuerteil (8) zum Steuern der Führung einer Bewegung der verdampften Substanz zu dem Abscheidungskörpers (3) innerhalb des rohrförmigen Körpers (4) vorgesehen ist, wobei ein Öffnungsbereich (5) des rohrförmigen Körpers (4) eine rechteckförmige Gestalt mit einer langen Seite (5a) und einer kurzen Seite (5b) hat und die Vorrichtung zur Vakuumabscheidung mit einem Mittel zum Bewegen des Abscheidungskörpers (3) versehen ist, welches Mittel zum Bewegen eine Größe derart hat, dass die Länge einer Linie, die sich entlang der langen Seite (5a) erstreckt, kürzer ist als die Länge der langen Seite (5a), und die Länge einer Linie, die sich entlang der kurzen Seite (5b) erstreckt, länger ist als die Länge der kurzen Seite (5b) in einer Richtung parallel zu der kurzen Seite (5b), um den Öffnungsbereich (5) zu passieren,
**dadurch gekennzeichnet, dass**
das Steuerteil (8) ein Paar von Hindernisplatten (10b) ist, die auf einer Seite nahe des Öffnungsbereichs (5) angeordnet und so vorgesehen sind, dass sie entgegengesetzt zu jeweils inneren Oberflächen nahe den langen Seiten (5a) des Öffnungsbereichs (5) vorstehen, und eine Breite eines Spaltes (30) zwischen den jeweils vorderen Enden der Hindernisplatten (10b) enger zu dem Mittelbereich der langen Seite (5a) in dem Öffnungsbereich (5) und weiter zu dem Endbereich hin wird.

2. Vorrichtung zur Vakuumabscheidung nach Anspruch 1, bei der das Steuerteil (8) auch eine poröse Platte (10a) enthält, die auf einer Seite nahe der Verdampfungsquelle (2) angeordnet und mit mehreren Durchgangslöchern (9), die die von der Verdampfungsquelle (2) verdampfte Substanz durchlassen, versehen ist.

3. Vorrichtung zur Vakuumabscheidung nach Anspruch 2, bei der die Dichte der mehreren Durchgangslöcher (9) in einem bestimmten Bereich des Steuerteils (8) hoch und in einem anderen bestimmten Bereich niedrig ist.

4. Vorrichtung zur Vakuumabscheidung nach Anspruch 3, bei der die Durchgangslöcher (9) mehr in einem Umfangsbereich als in einem Mittenbereich der porösen Platte (10a) verteilt sind.

5. Vorrichtung zur Vakuumabscheidung nach Anspruch 1, bei der das Steuerteil (8) so angeordnet ist, dass es angenähert parallel zu der Oberfläche ist, auf der das Abscheidungsmaterial abgeschieden wird.

6. Vorrichtung zur Vakuumabscheidung nach Anspruch 1, bei der das Steuerteil (8) auf eine Temperatur erwärmt ist, durch die die Substanz der Verdampfungsquelle (2) verdampft wird.

7. Vorrichtung zur Vakuumabscheidung nach Anspruch 1, bei der der Abscheidungskörper (3) als eine Platte mit einer angenähert quadratischen Form ausgebildet ist, bei der jede der Seiten gleich oder größer als 200 mm ist.

## Revendications

1. Dispositif de dépôt sous vide dans lequel une source d'évaporation (2) et un corps déposé (3) sont agencés dans une chambre sous vide (1), un espace entre la source d'évaporation (2) et le corps déposé (3) est entouré par un corps tubulaire (4) chauffé à une température à laquelle une substance de la source d'évaporation (2) est vaporisée, et la substance vaporisée depuis la source d'évaporation (2) est réalisée pour atteindre une surface du corps tubulaire (3) au travers d'un côté interne du corps tubulaire (4) de façon à être déposée, dans lequel un élément de commande (8) pour commander de façon à guider un mouvement de ladite substance vaporisée vers le corps déposé (3) dans ledit corps tubulaire (4) est agencé dans ledit corps tubulaire (4), dans lequel une partie d'ouverture (5) du corps tubulaire (4) est formée selon une forme rectangulaire constituée par une ligne longue (5a) et une ligne courte (5b), et le dispositif de dépôt sous vide est muni d'un moyen pour déplacer le corps déposé (3), ledit moyen pour déplacer ayant une amplitude telle que la longueur d'une ligne s'étendant le long de ladite ligne longue (5a) est plus courte que la longueur de ladite ligne longue (5a), et la longueur d'une ligne s'étendant le long de ladite ligne courte (5b) est plus longue que la longueur de ladite ligne courte (5b) dans une direction parallèle à ladite ligne courte (5b) de façon à venir au travers de ladite partie d'ouverture (5),
**caractérisé en ce que**
ledit élément de commande (8) est une paire de plaques d'obstacle (10b) qui sont agencées dans un côté proche de la partie d'ouverture (5) et sont agencées de façon à faire saillie en opposition à des surfaces internes respectives proches des lignes longues (5a) de la partie d'ouverture (5), et une largeur d'un espace (30) entre les extrémités avant respectives des plaques d'obstacle (10b) devient plus étroite vers la partie centrale de la ligne longue (5a) dans la partie d'ouverture (5) et plus large vers la partie d'extrémité.

2. Dispositif de dépôt sous vide selon la revendication 1, dans lequel ledit élément de commande (8) inclut également une plaque poreuse (10a) qui est agencée dans un côté proche de la source d'évaporation (2) et qui est munie d'une pluralité de trous traversants (9) laissant passer la substance évaporée depuis la source d'évaporation au travers.

3. Dispositif de dépôt sous vide selon la revendication 2, dans lequel la densité de la pluralité de trous traversants (9) est haute au niveau d'une zone spécifique de l'élément de commande (8) et basse au niveau d'une autre zone spécifique.

4. Dispositif de dépôt sous vide selon la revendication 3, dans lequel les trous traversants (9) sont distribués en plus grand nombre dans une partie périphérique que dans une partie centrale de la plaque poreuse (10a).

5. Dispositif de dépôt sous vide selon la revendication 1, dans lequel l'élément de commande (8) est agencé de façon à être approximativement parallèle à la surface au niveau de laquelle le matériau de dépôt est déposé.

6. Dispositif de dépôt sous vide selon la revendication 1, dans lequel l'élément de commande (8) est chauffé jusqu'à une température à laquelle la substance de la source d'évaporation (2) est vaporisée.

7. Dispositif de dépôt sous vide selon la revendication 1, dans lequel le corps déposé (3) est formé en tant qu'élément de plaque ayant une forme approximativement carrée dans laquelle chacune des lignes est égale à ou supérieure à 200 mm.
